# EUROPEAN PATENT APPLICATION

(11) **EP 1 148 156 A2**
(43) Date of publication of application: **24.10.2001**
(21) Application number: 01303373.3
(22) Date of filing: 10.04.2001
(51) Int. Cl.: C25D 3/38

(54) **Copper Electroplating**

(30) Priority: 11.04.2000 US 546811
(71) Applicant: Shipley Company LLC, Marlborough, MA 01752 (US)
(72) Inventor: Step, Eugene N., Newton, Massachusetts 02459 (US); Barstad, Leon R., Raynham, Massachusetts 02767 (US); Morrissey, Denis, Huntington, New York 11743 (US); Lefebvre, Mark, Hudson, New Hampshire 03051 (US)
(74) Representative: Kent, Venetia Katherine

(57) **Abstract**

Disclosed are compositions and methods for providing a planarized metal layer on a substrate having small features. The compositions and methods ofthe present invention provide complete fill of small features with reduced void formation.

## Description

### Background of the Invention

The present invention relates generally to the field of electrolytic plating compositions. In particular, the present invention relates to the field of copper electroplating compositions.

Methods for electroplating articles with metal coatings generally involve passing a current between two electrodes in a plating solution where one of the electrodes is the article to be plated. A typical acid copper plating solution comprises dissolved copper (usually copper sulfate), an acid electrolyte such as sulfuric acid in an amount sufficient to impart conductivity to the bath, and proprietary additives to improve the uniformity of the plating and the quality of the metal deposit. Such additives include brighteners, levelers, surfactants, suppressants, and the like.

Electrolytic copper plating solutions are used for many industrial applications. For example, they are used in the automotive industry to deposit base layers for subsequently applied decorative and corrosion protective coatings. They are also used in the electronics industry, particularly for the fabrication of printed circuit boards and semiconductors. For circuit board fabrication, copper is electroplated over selected portions of the surface of a printed circuit board and onto the walls of through holes passing between the surfaces of the circuit board base material. The walls of a through hole are first metallized to provide conductivity between the board's circuit layers. For semiconductor fabrication, copper is electroplated over the surface of a wafer containing a variety of features such as vias, trenches or a combination thereof. The vias and trenches arc metallized to provide conductivity between various layers of the semiconductor device.

It is well known in certain areas of plating, such as in electroplating of printed circuit boards, that the use of brighteners and/or levelers in the electroplating bath can be crucial in achieving a uniform metal deposit on a substrate surface. Plating a substrate having irregular topography can pose particular difficulties. During electroplating a voltage drop variation typically will exist along an irregular surface which can result in an uneven metal deposit. Plating irregularities are exacerbated where the voltage drop variation is relatively extreme, i.e., where the surface irregularity is substantial. As a result, a thicker metal deposit, termed overplating, is observed over such surface irregularities. Consequently, high quality metal plating (e.g., a metal layer or plate of substantially uniform thickness) is frequently a challenging step in the manufacture of electronic devices.

In the manufacture of printed circuit boards, the use of levelers, or leveling agents, in copper electroplating baths is well known. Such levelers arc typically organic compounds that are added to the electroplating bath to provide substantially uniform copper layers. For example, U.S. Patent No. 5,252,196 (Sonnenberg et al.) discloses the use of certain leveling agents containing a group of the formula N-R-S for use in the manufacture of printed wiring boards, where the leveling agent is present in an amount of less than 1 ppm. The manufacture of semiconductors is not disclosed.

The use of leveling agents in semiconductor manufacture is known but such agents are known to provide poor fill performance of small features, such as vias and trenches. For example, known leveling agents that have been used in semiconductor manufacture form substantially planar surfaces however, they also form a substantial number of voids in the vias or trenches. Such voids can cause electrical open circuits in the semiconductor. As the geometries of electronic devices get smaller, the difficulty of plating a uniform copper layer while completely filling the smaller features becomes more difficult.

One proposed solution is that found in U.S. Patent No. 6,024,857 (Reid) which discloses the use of certain leveling agents in the copper electroplating of wafers. In this patent, the leveling agents are selected such that they consist essentially of molecules having a size at least equal to the width of the feature to be plated. Such leveling agents are macromolecules, having molecular weights of from 200,000 to 10,000,000. Such an approach is problematic when features of different sizes arc present in the same substrate. Also, such leveling agents arc so large that they are removed from the plating baths during normal filtration processes to remove particulates.

Thus, there is a need in the art for leveling agents for use in semiconductor manufacture that do not form voids, show reduced overplating and are useful for plating substrates having different sized features.

### Summary of the Invention

It has been surprisingly found that the present invention provides metal layers, particularly copper layers, having reduced overplating. The metal layers provided by the present invention are substantially planar, even on substrates having very small features. It has been further surprisingly found that the present invention provides metal layers substantially without the formation of added defects, such as voids, in the features, and in particular copper layers without the formation of defects, such as voids, in very small features.

In one aspect, the present invention provides a composition for the electroplating of copper on a semiconductor device including electrolyte, one or more sources of copper ions, one or more brighteners and a leveling agent capable of providing a substantially planar copper layer and filling small features without substantially forming defects, wherein the brightener is present in an amount of at least about 1 mg/L, based on the bath.

In a second aspect the present invention provides a method of electroplating copper on a substrate having small features including the steps of contacting a substrate to be plated with a copper electroplating bath including a leveling agent capable of providing a substantially planar copper layer and filling small features without substantially forming defects, and subjecting the bath to a current density and for a period of time sufficient to deposit a copper layer on the substrate.

In a third aspect, the present invention provides a method of manufacturing an electronic device including the steps of contacting a substrate to be plated with a copper electroplating bath including a leveling agent capable of providing a substantially planar copper layer and filling small features without substantially forming defects, and subjecting the bath to a current density and for a period of time sufficient to deposit a copper layer on the substrate.

In a fourth aspect, the present invention provides a method of reducing overplating in a copper layer of a semiconductor device including the steps of contacting a substrate to be plated with a copper clectroplating bath including a leveling agent capable of providing a substantially planar copper layer and filling small features without substantially forming defects, and subjecting the bath to a current density and for a period of time sufficient to deposit a copper layer on the substrate.

In a fifth aspect, the present invention provides an apparatus including a substrate having a substantially planar copper layer and filled small features wherein the small features are substantially free of added defects, and wherein the copper layer has not been subjected to polishing processes.

### Brief Description of the Drawings

Fig. 1 is a FIB micrograph of a control sample showing overplating of copper on 0.3 µm trenches.
Fig. 2 is a FIB micrograph of a sample of the invention showing substantially no overplating of copper on 0.3 µm trenches.
Fig. 3 is a FIB micrograph showing overplating of copper on 0.25 µm vias.
Fig. 4 is a FIB micrograph showing substantially no overplating of copper on 0.25 µm vias.

### Detailed Description of the Invention

As used throughout this specification, the following abbreviations shall have the following meanings, unless the context clearly indicates otherwise: A = amperes; mA/cm² = milliamperes per square centimeter; ° C = degrees Centigrade; g = gram; mg = milligram; Å = angstrom; L = liter, ppm = parts per million; ppb = parts per billion; µm = micron; cm = centimeter; RPM = revolutions per minute; DI = deionized; and mL = milliliter. All amounts arc percent by weight and all ratios are by weight, unless otherwise noted. All numerical ranges are inclusive and combinable.

By "feature" is meant the geometries on a substrate, such as, but not limited to, trenches and vias. The term "small features" refers to features that are one micron or smaller in size. "Very small features" refers to features that are one-half micron or smaller in size. "Halide" refers to fluoride, chloride, bromide and iodide. Likewise, "halo" refers to fluoro, chloro, bromo and iodo. The term "alkyl" includes linear, branched and cyclic alkyl. The terms "levelers" and "leveling agents" are used interchangeably throughout this specification.

The present invention provides a plated metal layer, particularly a plated copper layer, on a substrate containing small features wherein the metal layer has reduced overplating and the small features are substantially free of added voids, and preferably substantially free of voids. "Overplating" refers to a thicker metal deposit over dense feature areas as compared to areas free of or substantially free of features. Such difference in the plating thickness over dense feature areas as compared to the plating thickness over areas free of or substantially free of features is referred to as "step height." Suitable substrates are any used in the manufacture of electronic devices, such as those used in the manufacture of printed wiring boards or semiconductors. Particularly suitable substrates are wafers used in semiconductor manufacture, and more particularly wafers used in dual damascene manufacturing processes. It is preferred that the substrate contains very small features. The present invention is particularly suited for use in plating substrates having sub-half-micron features or smaller, more particularly 0,3 micron features or smaller and most particularly 0.25 micron features or smaller. It is further preferred that the small features are free of added voids. The present invention is particularly suitable for filling high aspect ratio vias and trenches, such as those having aspect ratios of 4:1 or greater such as 10:1, with copper such that the vias or trenches are substantially free of voids and preferably free of voids, and more particularly the present invention is suitable for filling high aspect ratio trenches. It will be appreciated by those skilled in the art that the present invention is also useful in filling features that are greater than 1 micron.

The present invention is achieved by combining a leveling agent capable of providing a substantially planar copper layer and filling features without substantially forming defects, such as but not limited to voids, with a metal electroplating bath, preferably a copper electroplating bath. Suitable leveling agents include, but are not limited to one or more of nigrosines, pentamethyl-para-rosanilinc hydrohalide, hexamethyl-para-rosaniline hydrohalide, or compounds containing a functional group of the formula N-R-S, wherein R is a substituted alkyl, unsubstituted alkyl, substituted aryl or unsubstituted aryl.

In general, such metal electroplating baths include electrolyte, one or more sources of metal ions, one or more brighteners and optionally other additives. Such baths are typically aqueous. Suitable electrolytes include such as, but not limited to, sulfuric acid, acetic acid, fluoroboric acid, methane sulfonic acid, ethane sulfonic acid, trifluoromethane sulfonic acid, phenyl sulfonic acid, methyl sulfamic acid, p-toluenesulfonic acid, hydrochloric acid, phosphoric acid and the like. The acids are typically present in an amount in the range of from about 1 to about 300 g/L, and preferably from about 150 to about 250 g/L. Such electrolytes may optionally contain a source of halide ions, such as chloride ions such as copper chloride or hydrochloric acid. A wide range of halide ion concentrations may be used in the present invention. Typically, the halide ion concentration is in the range of from about 0 to about 100 ppm based on the plating bath, and preferably from about 25 to about 75 ppm. It is preferred that the electrolyte is sulfuric acid, and preferably a mixture of sulfuric acid and a source of chloride ions. The acids and sources of halide ions useful in the present invention are generally commercially available and may be used without further purification.

Any metal ion source that is at least partially soluble in the electroplating bath is suitable. It is preferred that the metal ion source is soluble in the plating bath. Suitable metal ion sources are metal salts and include, but are not limited to, metal sulfates, metal halides, metal acetates, metal nitrates, metal fluoroborates, metal methane sulfonates, metal phenyl sulfonates, metal sulfamates, metal p-toluene sulfonates and the like. It is preferred that the metal is copper. It is further preferred that the source of metal ions is copper sulfate, copper chloride, copper acetate, copper nitrate, copper fluoroborate, copper methane sulfonate, copper phenyl sulfonate and copper p-toluene sulfonate. Copper sulfate pentahydrate is particularly preferred. Such metal salts are generally commercially available and may be used without further purification.

The metal salts may be used in the present invention in any amount that provides sufficient metal ions for electroplating on a substrate. Suitable metal salts include, but are not limited to, tin salts, copper salts, and the like. When the metal is copper, the copper salt is typically present in an amount in the range of from about 10 to about 300 g/L of plating solution, preferably from about 25 to about 200 g/L, and more preferably from about 40 to about 175 g/L. It will be appreciated mixtures of metal salts may be electroplated according to the present invention. Thus, alloys, such as copper-tin having up to about 2 percent by weight tin, may be advantageously plated according to the present invention. The amounts of each of the metal salts in such mixtures depends upon the particular alloy to be plated and is well known to those skilled in the art.

Any brighteners or brightening agents are suitable for use in the present invention. Typical brighteners contain one or morc sulfur atoms and have a molecular weight of about 1000 or less. Brightener compounds that have sulfide and/or sulfonic acid groups are generally preferred, particularly compounds that include a group of the formula R'-S-R-SO₃X, where R is optionally substituted alkyl, optionally substituted heteroalkyl, optionally substituted aryl, or optionally substituted heterocyclic; X is a counter ion such as sodium or potassium; and R' is hydrogen or a chemical bond. Typically, the alkyl groups are (C₁-C₁₆)alkyl and preferably (C₃-C₁₂)alkyl. Heteroalkyl groups typically have one or more heteroatoms, such as nitrogen, sulfur or oxygen, in the alkyl chain. Suitable aryl groups include, but are not limited to, phenyl, benzyl, biphenyl and naphthyl. Suitable heterocyclic groups typically contain from 1 to about 3 heteroatoms, such as nitrogen, sulfur or oxygen, and 1 to 3 separate or fused ring systems. Such heterocyclic groups may be aromatic or non-aromatic. Specific brighteners suitable for use in the present invention include, but are not limited to, N,N-dimethyl-dithiocarbamic acid-(3-sulfopropyl)ester; 3-mercapto-propylsulfonic acid-(3-sulfopropyl)ester; 3-mercapto-propylsulfonic acid sodium salt; carbonic acid-dithio-o-ethylester-s-ester with 3-mercapto-1-propane sulfonic acid potassium salt; bis-sulfopropyl disulfide; 3-(benzothiazolyl-s-thio)propyl sulfonic acid sodium salt; pyridinium propyl sulfobetaine; 1-sodium-3-mercaptopropane-1-sulfonate; and the like.

Such brighteners are typically used in an amount of at least about 1 mg/L, based on the bath, preferably at least about 1.2 mg/L, and more preferably at least about 1.5 mg/L. For example, the brighteners are present in an amount of from about 1 mg/L to about 200 mg/L. Particularly suitable amounts of brightener useful in the present invention are at least about 2 mg/L, and more particularly at least about 4 g/L. Even higher brightener concentrations are preferred, such as at least about 10, 15, 20, 30, 40 or 50 mg/L, based on the bath.

The leveling agents useful in the present invention are any which are capable of providing a substantially planar copper layer and filling small features without substantially forming voids. Suitable leveling agents include, but are not limited to, one or more of nigrosines, pentamethyl-para-rosaniline hydrohalide, hexamethyl-para-rosaniline hydrohalide, or compounds containing a functional group of the formula N-R-S, where R is a substituted alkyl, unsubstituted alkyl, substituted aryl or unsubstituted aryl, Typically, the alkyl groups are (C₁-C₆)alkyl and preferably (C₁-C₄)alkyl. In general, the aryl groups include (C₆-C₂₀)aryl, preferably (C₆-C₁₀)aryl. Such aryl groups may further include heteroatoms, such as sulfur, nitrogen and oxygen. It is preferred that the aryl group is phenyl or napthyl. The compounds containing a functional group of the formula N-R-S are generally known, are generally commercially available and may be used without further purification.

In such compounds containing the N-R-S functional group, the sulfur ("S") and/or the nitrogen ("N") may be attached to such compounds with single or double bonds. When the sulfur is attached to such compounds with a single bond, the sulfur will have another substituent group, such as but not limited to hydrogen, (C₁-C₁₂)alkyl, (C₂-C₁₂)alkenyl, (C₆-C₂₀)aryl, (C₁-C₁₂)alkylthio, (C₂-C₁₂)alkenylthio, (C₆-C₂₀)arylthio and the like, Likewise, the nitrogen will have one or more substituent groups, such as but not limited to hydrogen, (C₁-C₁₂)alkyl, (C₂-C₁₂)alkenyl, (C₇-C₁₀)aryl, and the like. The N-R-S functional group may be acyclic or cyclic. Compounds containing cyclic N-R-S functional groups include those having either the nitrogen or the sulfur or both the nitrogen and the sulfur within the ring system.

By "substituted alkyl" is meant that one or more of the hydrogens on the alkyl group is replaced with another substituent group, such as, but not limited to, cyano, hydroxy, halo, (C₁-C₆)alkoxy, (C₁-C₆)alkylthio, thiol, nitro, and the like. By "substituted aryl" is meant that one or more hydrogens on the aryl ring are replaced with one or more substituent groups, such as, but not limited to, cyano, hydroxy, halo, (C₁-C₆)alkoxy, (C₁-C₆)alkyl, (C₂-C₆)alkenyl, (C₁-C₆)alkylthio, thiol, nitro, and the like. "Aryl" includes carbocyclic and heterocyclic aromatic systems, such as, but not limited to, phenyl, naphthyl and the like.

The nigrosines useful as levelers in the present invention refer to the class of black or deep-bluc azine dyes obtained by oxidation of aniline or its homologues. It is preferred that the nigrosines is pure nigrosine, i.e. aniline black, having the formula C₃₈H₂₇N₃. Such nigrosines useful in the present invention are generally commercially available and may be used without further purification.

The pentamethyl-para-rosaniline hydrohalide and hexamethyl-para-rosanilinc hydrohalide may be used in any hydrohalide form. It is preferred that they arc used as their hydrochlorides. It is further preferred that pentamethyl-para-rosaniline hydrohalide and hexamethyl-para-rosaniline hydrohalide arc used in admixture. A particularly suitable mixture is pentamethyl-para-rosaniline hydrochloride and hexamethyl-para-rosaniline hydrochloride, generally commercially available as methyl violet or crystal violet.

It is preferred that the leveling agents of the present invention are 1-(2-hydroxyethyl)-2-imidazolidinethione, mercaptopyridine such as 4-mercaptopyridine and 2-mercaptopyridine, mercaptothiazoline such as 2- mercaptothiazoline, ethylene thiourea, thiourea, alkylated polyalkyleneimine, pentamethyl-para-rosaniline hydrochloride, hexamethyl-para-rosaniline hydrochloride, mixtures of pentamethyl-para-rosaniline hydrochloride and hexamethyl-para-rosaniline hydrochloride, and nigrosines. It is more preferred that the leveling agent is 1-(2-hydroxyethyl)-2-imidazolidinethione, nigrosine, and mixtures of pentamethyl-para-rosaniline hydrochloride and hexamethyl-para-rosaniline hydrochloride, and most preferably 1-(2-hydroxyethyl)-2-imidazolidinethione.

It will be appreciated by those skilled in the art that more than one leveling agent may be used advantageously in the present invention. Thus mixtures of the leveling agents of the present invention may be employed. In the alternative, mixtures of one or more leveling agents of the present invention along with one or more known leveling agents may be used.

The leveling agents of the present invention are typically used in an amount in the range of from about 0.1 ppm to about 10 ppm based on the total weight of the plating bath, although greater amounts may be used. It is preferred that the leveling agent is present in an amount of from about 0.25 to about 5 ppm and more preferably from about 0.5 to about 3 ppm. It is preferred that as the amount of leveling agent is increased in the plating bath that the amount of brightener is also increased. Amounts of leveling agent greater than about 1 ppm are particularly useful in certain plating baths.

The leveling agents of the present invention are not macromolecular compounds. It is preferred that the leveling agents of the present invention have molecular weights less than about 10,000, preferably less than about 5000, more preferably less than about 1000, and even more preferably less than about 600.

The electroplating baths of the present invention may include one or more optional additives. Such optional additives include, but are not limited to, suppressors, surfactants and the like. Such suppressors and brighteners are generally known in the art. It will be clear to one skilled in the art which suppressors and/or brighteners to use and in what amounts.

Suppressors useful in the present invention include, but are not limited to, polymeric materials, particularly those having heteroatom substitution, and more particularly oxygen substitution. It is preferred that the suppressor is a high molecular weight polyether, such as those of the formula:

R-O-(CXYCX'Y'O)ₙH

where R is a (C₂-C₂₀)alkyl group or (C₆-C₁₀)aryl group; each of X, Y, X' and Y' is independently selected from hydrogen, alkyl such as methyl, ethyl or propyl, aryl such as phenyl, or aralkyl such as benzyl; and n is an integer from 5 to 100,000. It is preferred that one or more of X, Y, X' and Y' is hydrogen. It is further preferred that R is ethylene. It is more preferred that R is ethylene and n is greater than 12,000. Particularly suitable suppressors include commercially available polyethylene glycol copolymers, including ethylene oxide-propylene oxide copolymers and butyl alcohol-ethylene oxide-propylene oxide copolymers. Suitable butyl alcohol-ethylene oxide-propylene oxide copolymers are those having a weight average molecular weight of about 1800.

When suppressors are used, they are typically present in an amount in the range of from about 1 to about 10,000 ppm based on the weight of the bath, and preferably from about 5 to about 10,000 ppm.

Particularly suitable compositions useful as electroplating baths in the present invention include one or more soluble copper salts, one or more acids, one or more leveling agents and one or more brighteners, wherein the brighteners are present in a concentration of at least about I mg/L of the bath. More particularly suitable compositions include about 10 to about 300 g/L of one or more soluble copper salts, about 150 to about 250 g/L of one or more acids, about *25* to about 75 ppm of a halide ion, about 0.1 to about 10 ppm of one or more leveling agents selected from nigrosines, pentamethyl-para-rosaniline hydrohalide, hexamethyl-para-rosaniline hydrohalide, or compounds containing a functional group of the formula N-R-S, wherein R is a substituted alkyl, unsubstituted alkyl, substituted aryl or unsubstituted aryl, and one or more brighteners, wherein the brighteners are present in a concentration of at least about 1 mg/L of the bath. It is preferred that these compositions further contain a suppressor. It is further preferred that the suppressor is present in an amount of from about 5 to about 10,000 ppm.

The electroplating baths of the present invention may be prepared by combining the components in any order. It is preferred that the inorganic components such as metal salts, water, acid and optional halide ion source, are first added to the bath vessel followed by the organic components such as leveling agents, brighteners, suppressors, surfactants and the like.

Typically, the plating baths of the present invention may be used at any temperature from about 15° to about 65° C or higher. It is preferred that the temperature of the plating baths is from 15° to 35° C and more preferably from 20° to 30° C.

In general, when the present invention is used to deposit metal on a substrate such as a printed wiring board, the plating baths are agitated during use. Any suitable agitation method may be used with the present invention. Suitable agitation methods include, but are not limited to, air sparging, work piece agitation, impingement and the like. Such methods are known to those skilled in the art. When the present invention is used to plate a semiconductor substrate, such as a wafer, the wafer may be rotated such as from 1 to 150 RPM and the plating solution contacts the rotating wafer, such as by pumping or spraying. In the alternative, the wafer need not be rotated where the flow of the plating bath is sufficient to provide the desired metal deposit.

Typically, substrates arc electroplated by contacting the substrate with the plating baths of the present invention. Typically, the bath is subjected to a current density for a period of time sufficient to deposit a copper layer on the substrate. Suitable current densities, include, but are not limited to, the range of about 1 to about 40 mA/cm², It is preferred that the current densities are from about 3 to about 30 mA/cm². The specific current density depends upon the substrate to be plated, the leveling agent selected and the like. Such current density choice is within the skill of one in the art.

The present invention may be used to electroplate a variety of substrates, particularly those having small features. For example, the present invention is particularly suitable for depositing copper on circuit board substrates with small diameter, high aspect ratio vias, trenches or other apertures as well as for plating integrated circuit devices, such as semiconductor devices. It is preferred that semiconductor devices are plated according to the present invention. Such semiconductor devices include, but arc not limited to, wafers used in the manufacture of semiconductors.

In particular, the present invention provides a method for manufacturing a semiconductor device including the steps of providing at least one of vias or trenches in a substrate having a conductive layer, electrolytically plating a metallic layer over the conductive layer using an electrolytic plating bath including one or more soluble copper salts, one or more acids, one or more leveling agents capable of providing a substantially planar metal layer and filling features without substantially forming voids, and one or more brighteners, wherein the brighteners are present in a concentration of at least about 1 mg/L of the bath. More particularly, the present invention provides a method for manufacturing a semiconductor device including the steps of providing at least one of vias or trenches in a substrate having a conductive layer, electrolytically plating a metallic layer over the conductive layer using an electrolytic plating bath including 10 to about 300 g/L of one or more soluble copper salts, about 100 to about 300 g/L of one or more acids, about 25 to about 75 ppm of a halide ion, about 0.1 to about 10 ppm of one or more leveling agents selected from nigrosines, pentamethyl-para-rosaniline hydrohalide, hexamethyl-para-rosaniline hydrohalide, or compounds containing a functional group of the formula N-R-S, wherein R is a substituted alkyl, unsubstituted alkyl, substituted aryl or unsubstituted aryl, and one or more brighteners, wherein the brighteners are present in a concentration of at least about 1 mg/L of the bath.

While the process of the present invention has been generally described with reference to semiconductor manufacture, it will be appreciated that the present invention may be useful in any electrolytic process where reduced overplating and metal filled small features that are substantially free of voids are desired. Such processes include printed wiring board manufacture.

An advantage of the present invention is that overplating is reduced or substantially eliminated. Such reduced overplating means less time and effort is spent in removing metal, such as copper, during subsequent chemical-mechanical polishing ("CMP") process, particularly in semiconductor manufacture Thus, apparatuses including substrates, such as semiconductor devices, wafers, printed circuit boards and the like, are formed according to the present invention having substantially planar copper layers and filled small features that are substantially free of added defects, wherein the copper layer has not been subjected to polishing processes, such as CMP process. By "substantially planar" copper layer is meant that the step height difference between areas of dense very small features and areas free of or substantially free of very small features is less than 1 µm, preferably less than 0.75 µm, more preferably less than 0.6 µm, and even more preferably less than 0.1 µm. "Substantially free of added defects" refers to the leveling agent not increasing the number or size of defects, such as voids, in very small features as compared to control plating baths not containing such leveling agent. A further advantage of the present invention is that a substantially planar metal layer may be deposited on a substrate having non-uniformly sized small features, wherein the features are substantially free of added voids, with the use of a single leveling agent. "Non-uniformly sized small features" refer to small features having a variety of sizes in the same substrate. Thus, the need to tailor the leveling agent to the size of the feature to be filled is avoided.

The following examples are intended to illustrate further various aspects of the present invention, but are not intended to limit the scope of the invention in any aspect.

### Example 1

Blanket 8 inch (ca. 20.3 cm) wafers, i.e. wafers having no features, having a 250 Å tantalum barrier layer and a 1000 Å physical vapor deposited ("PVD") copper seed layer were plated in a copper bath containing 175 g/L sulfuric acid, 17.5 g/L copper ions as copper sulfate, 50 ppm chloride ions as hydrochloric acid, 800 ppm of an EO/PO copolymer having a molecular weight of 2400, and bis-sodium-sulfonopropyl-disulfide as brightener. The control wafer was plated with a bath containing no leveling agent. Wafers A and B (invention) were plated with a bath containing 1-(2-hydroxyethyl)-2-imidazolidinethione as leveling agent. The amount of brightener and leveling agent in the plating baths is reported in Table 1. The wafers were electrically attached to a cathode and the plating solution was pumped onto the surface of the wafer while rotating at upwards of 20 RPM. The following rectification sequence was used to plated the wafers: Step 1:1.0 A current and 0.08 A-min total charge; Step 2: 4.5 A current and 4.40 A-min total charge; and Step 3: 6.0 A current and 10.5 A-min total charge. The wafers were plated at 25° C.

Global within-wafer non-uniformity was measured immediately after plating with a resistivity mapping tool using 49 points. The non-uniformity of the plating is reported in Table 1 as the standard deviation in the thickness of the copper layer.

**Table 1**

| Wafer Sample | Brightener (mL/L) | Leveler (ppm) | Non-Uniformity (%) |
|---|---|---|---|
| Control 1 | 3 | 0 | 3.47 |
| A | 6 | 1 | 3.29 |
| B | 9 | 2 | 2.48 |

These data clearly show that the leveling agents of the present invention provide greater within-wafer uniformity of plated copper layers than when such layers are plated without the use of leveling agents.

### Example 2

Trench patterned 8 inch (ca. 20.3 cm) wafers each having a 250 Å tantalum barrier layer and a 1000 Å PVD seed layer of copper were plated in a tool to deposit about 1 µm of copper. The wafers contained 0.2 µm, 0.3 µm, 1 µm and 2 µm trenches. The wafers were plated using the copper bath of Example 1. Control Wafer 2 was plated using the same bath as Control Wafer 1 in Example 1. Wafers C to F (invention) were plated with a bath containing 1-(2-hydroxyethyl)-2-imidazolidinethione as leveling agent. The amount of brightener and leveling agent in the plating baths is reported in Table 2.

**Table 2**

| Wafer Sample | Brightener (mL/L) | Leveler (ppm) |
|---|---|---|
| Control 2 | 3 | 0 |
| C | 3 | 1 |
| D | 6 | 1 |
| E | 9 | 2 |
| F | 6 | 1 |

Electrical current was applied to the bath with DC wave form at 25° C, according to the procedure of Example 1. After plating, the wafers were rinsed with DI water and dried. After drying, the wafers were examined using FIB microscopy.

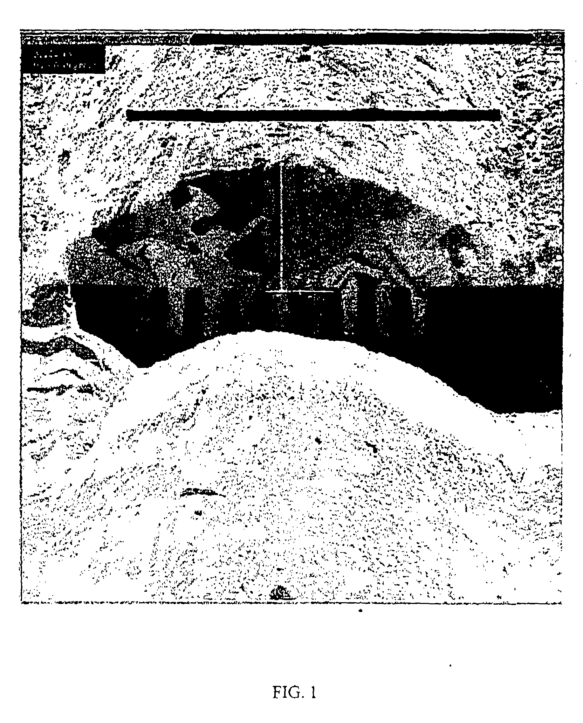

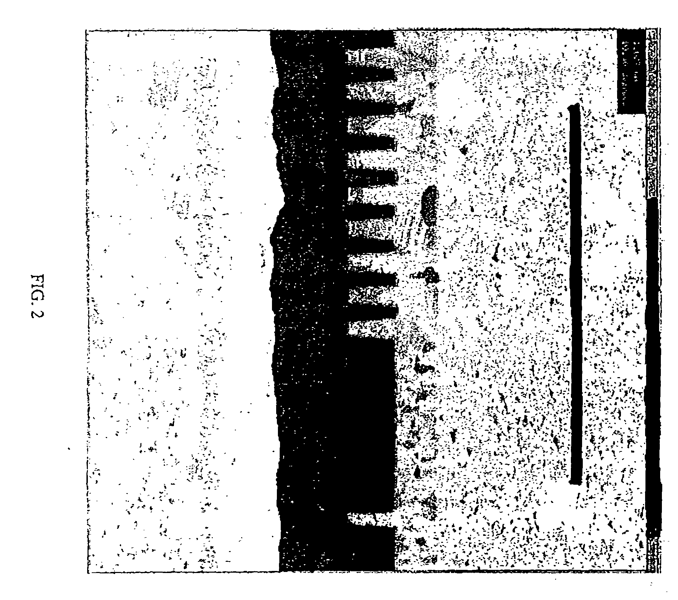

Fig. 1 is a FIB micrograph of the Control Wafer 2 showing overplating of copper on 0.3 µm trenches. Fig. 2 is a FIB micrograph of Wafer E showing substantially no overplating of copper on 0.3 µm trenches. The figures clearly show the leveling agent of the present invention is effective in reducing overplating. All samples, invention and control, had plated trenches that were void free

The plating step heights, i.e. the differences in plating thicknesses over dense features from plating thicknesses over planar areas, are reported in microns in the Table 3.

**Table 3**

| Step Height | | | | | |
|---|---|---|---|---|---|
| Wafer Sample | 0.2 µm Trench (µm) | 0.3 µm Trench (µm) | 0.5 µm Trench (µm) | I µm Trench (µm) | 2 µm Trench (µm) |
| Control 2 | 1.5 | 1.19 | 1.37 | 0.88 | 0.48 |
| C | 0.1 | -0.1 | -0.1 | -0.09 | -0.07 |
| D | 0.5 | 0.4 | 0 | 0.07 | -0.05 |
| E | 0.1 | 0 | 0 | -0.24 | -0.6 |
| F | 0.6 | 0.43 | -0.1 | -0.09 | -0.4 |

A negative step height indicates plating thickness is greater over planar area than over dense features area. These results clearly show that the levelers of the present invention greatly reduce overplating, particularly over very small features.

### Example 3

Via patterned 8 inch (ca. 20.3 cm) wafers each having a 250 Å tantalum barrier layer and a 1000 Å PVD seed layer of copper were plated in a tool to electrolytically deposit copper. The wafers contained 0.22 µm, 0.25 µm, 0.3 µm and 0.6 µm vias. The wafers were plated using the copper bath of Example 1. Control Wafer 3 was plated using the same bath as Control Wafer 1 in Example 1, Wafer G (invention) was plated according to the procedure of Example I and using a bath containing 1 ppm 1-(2-hydroxyethyl)-2-imidazolidinethione as leveling agent and 6 mL/L of bis-sodium-sulfonopropyl-disulfide as brightener.

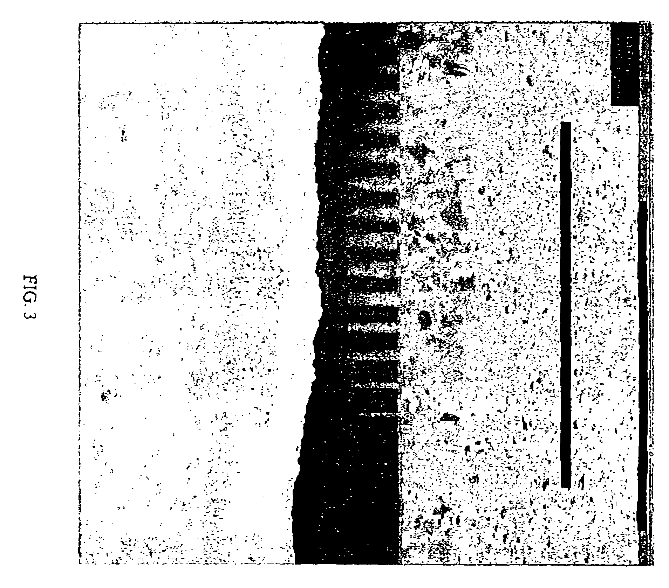

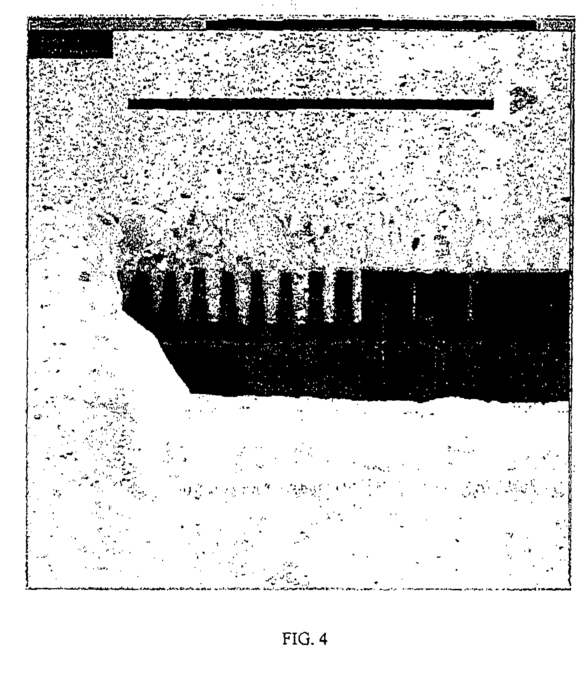

After plating, the wafers were rinsed with DI water and dried. After drying, the wafers were examined using FIB microscopy. Fig. 3 is a FIB micrograph of the Control Wafer 3 showing overplating of copper on 0.25 µm vias. Fig. 4 is a FIB micrograph of Wafer G showing substantially no overplating of copper on 0.25 µm trenches. The figures clearly show the leveling agent of the present invention is effective in reducing overplating. Both the control wafer and Wafer G showed bottom voids in the 0.22 µm vias. However, Wafer G showed no increase in void formation as compared with the control wafer. Inspection of the wafers after plating showed that Wafer G contained so bright and leveled a copper layer that almost no pattern could be seen on. In comparison, Control Wafer 3 showed well resolved circuitry.

The plating step heights, i.e. the differences in plating thicknesses over dense features from plating thicknesses over planar areas, are reported in microns in the Table 4.

**Table 4**

| Step Height | | | | |
|---|---|---|---|---|
| Wafer Sample | 0.22 µm Via (µm) | 0.25 µm Via (µm) | 0.3 µm Via (µm) | 0.6 µm Via (µm) |
| Control 3 | -0.05 | 0.56 | N/A | 1.28 |
| G | -0.05 | 0.02 | -0.1 | 0.05 |

A negative step height indicates plating thickness is greater over planar area than over dense features area. These results clearly show that the levelers of the present invention greatly reduce overplating, particularly over very small features.

### Example 4

Control Wafer 2 and Wafers C-E from Example 2 were examined by atomic force microscopy ("AFM"). The surfaces of Wafers C-E were found to be substantially smoother than the surface of Control Wafer 2. The data are reported in Table 5. "Location" refers to the location of the measurement on the wafer, either center or edge and "Ra" refers to the average roughness.

**Table 5**

| Sample | Location | Ra(Å) |
|---|---|---|
| Control Wafer 2 | Center | 136.3 |
| | Edge | 121.6 |
| | | |
| C | Center | 67.7 |
| | Edge | 63.2 |
| | | |
| D | Center | 102.9 |
| | Edge | 94.0 |
| | | |
| E | Center | 69.7 |
| | Edge | 65.0 |

Thus, the leveling agents of the present invention not only provide a substantially planar surface, but also provide a cooper layer having decreased surface roughness.

### Example 5 (Comparative)

Known leveling agents were evaluated in the plating of semiconductor wafers. The leveling agents tested were Jeffamine™ T-403 tertiary amine (available from Texaco) Janus Green B, Tetronic™ 90R4 tertiary amine (available from BASF) and a reaction mixture of epichlorohydrin and imidazole. In each case, the resulting copper deposit was level, but significant void formation was observed in the small features plated.

## Claims

1. A composition for the electroplating of copper on a semiconductor device comprising electrolyte, one or more sources of copper ions, one or more brighteners and a leveling agent capable of providing a substantially planar copper layer and filling small features without substantially forming defects, wherein the brightener is present in an amount of at least about 1 mg/L, based on the bath.

2. The composition of claim 1 wherein the leveling agent is present in an amount of from about 0.1 to about 10 ppm, based on the bath.

3. The composition of claim 1 wherein the leveling agent is selected from one or more of nigrosines, pentamethyl-para-rosaniline hydrohalide, hexamethyl-para-rosaniline hydrohalide, or compounds containing a functional group of the formula N-R-S, where R is a substituted alkyl, unsubstituted alkyl, substituted aryl or unsubstituted aryl.

4. The composition of claim 1 wherein the leveling agent is 1-(2-hydroxyethyl)-2-imidazolidinethione.

5. The composition of claim 1 wherein the electrolyte further comprises a source of halide ions.

6. The composition of claim 1 wherein the electrolyte is sulfuric acid.

7. A method of electroplating copper on a substrate having small features comprising the steps of contacting a substrate to be plated with a copper electroplating bath comprising a leveling agent capable of providing a substantially planar copper layer and filling features without substantially forming defects, and subjecting the bath to a current density and for a period of time sufficient to deposit a copper layer on the substrate.

8. The method of claim 7 wherein the leveling agent is selected from one or more of nigrosines, pentamethyl-para-rosaniline hydrohalide, hexamethyl-para-rosaniline hydrohalide, or compounds containing a functional group of the formula N-R-S, where R is a substituted alkyl, unsubstituted alkyl, substituted aryl or unsubstituted aryl.

9. The method of claim 8 wherein the leveling agent is present in an amount of from about 0.1 to about 10 ppm, based on the bath.

10. The method of claim 7 wherein the leveling agent is 1-(2-hydroxyethyl)-2-imidazolidinethione.

11. The method of claim 7 wherein the copper electroplating bath comprises one or more brighteners wherein the brightener is present in an amount of at least about 1 mg/L, based on the bath.

12. A method of manufacturing an electronic device comprising the steps of contacting a substrate to be plated with a copper electroplating bath comprising a leveling agent capable of providing a substantially planar copper layer and filling features without substantially forming defects, and subjecting the bath to a current density and for a period of time sufficient to deposit a copper layer on the substrate.

13. The method of claim 12 wherein the leveling agent is selected from one or more of nigrosines, pentamethyl-para-rosaniline hydrohalide, hexamethyl-para-rosaniline hydrohalide, or compounds containing a functional group of the formula N-R-S, where R is a substituted alkyl, unsubstituted alkyl, substituted aryl or unsubstituted aryl.

14. The method of claim 12 wherein the leveling agent is present in an amount of from about 0.1 to about 10 ppm, based on the bath.

15. The method of claim 12 wherein the leveling agent is 1-(2-hydroxyethyl)-2-imidazolidinethione.

16. The method of claim 12 wherein the copper electroplating bath comprises one or more brighteners wherein the brightener is present in an amount of at least about 1 mg/L, based on the bath.

17. A method of reducing over plating in a copper layer of a semiconductor device comprising the steps of contacting a substrate to be plated with a copper electroplating bath comprising a leveling agent capable of providing a substantially planar copper layer and filling features without substantially forming defects, and subjecting the bath to a current density and for a period of time sufficient to deposit a copper layer on the substrate.

18. The method of claim 17 wherein the leveling agent is present in an amount of from about 0.1 to about 10 ppm, based on the bath.

19. The method of claim 17 wherein leveling agent is selected from one or more of nigrosines, pentamethyl-para-rosaniline hydrohalide, hexamethyl-para-rosaniline hydrohalide, or compounds containing a functional group of the formula N-R-S, where R is a substituted alkyl, unsubstituted akyl, substituted aryl or unsubstituted aryl.

20. The method of claim 17 wherein the leveling agent is 1-(2-hydroxyethyl)-2-imidazolidinethione.

21. An apparatus comprising substrate having a substantially planar copper layer and filled small features wherein the small features are substantially free of added defects, and wherein the copper layer has not been subjected to polishing processes.

22. The apparatus of claim 22 wherein the substrate is a semiconductor device, wafer or printed circuit board.

23. The apparatus of claim 21 wherein the polishing process is a chemical-mechanical polishing process.

24. The apparatus of claim 21 wherein the small features are non-uniformly sized.
